# EUROPÄISCHE PATENTANMELDUNG

(11) **EP 2 437 394 A1**
(43) Veröffentlichungstag der Anmeldung: **04.04.2012**
(21) Anmeldenummer: 11178375.9
(22) Anmeldetag: 23.08.2011
(51) Int. Cl.: H03G 9/02, H04R 25/00

(54) **Verfahren zur Signalverarbeitung in einem Hörhilfegerät sowie Hörhilfegerät**

(30) Priorität: 30.09.2010 DE 102010041740
(71) Anmelder: Siemens Medical Instruments Pte. Ltd., Singapore 139959 (SG)
(72) Erfinder: Kornagel, Ulrich, 91052 Erlangen (DE); Latzel, Matthias, 91330 Eggolsheim (DE); Petrausch, Stefan, 91056 Erlangen (DE); Tiefenau, Andreas, 1506 BR Zaandam (NL)
(74) Vertreter: Maier, Daniel Oliver

(57) **Zusammenfassung**

Bei einem zur Durchführung einer Dynamikkompression geeigneten Hörhilfegerät soll die die Wahrnehmung akustischer Signale bei der Versorgung eines Schwerhörigen weiter verbessert werden. Hiezu wird vorgeschlagen, ein Eingangssignals in mehrere Frequenzbänder (FB41, FB42, FB43, FB44; FB51, FB52, FB53, FB54) aufzuteilen, eine eingangspegelgesteuerten Dynamikkompression in wenigstens einem ersten Frequenzband (FB43, FB44) und eine ausgangspegelgesteuerte Dynamikkompression in wenigstens einem zweiten Frequenzband (FB41, FB42) auszuführen. Dadurch werden sowohl der Lautheitseindruck als auch das Sprachverstehen optimiert.

## Beschreibung

Verfahren zur Signalverarbeitung in einem Hörhilfegerät sowie Hörhilfegerät

Die Erfindung betrifft ein Verfahren zur Signalverarbeitung in einem Hörhilfegerät sowie ein Hörhilfegerät, bei denen eine Aufteilung eines Eingangssignals in mehrere Frequenzbänder erfolgt.

Bei Hörhilfegeräten ist es üblich, zur Kompensation eines Hörverlustes eines Benutzers eine Dynamik-Kompression zu verwenden, insbesondere beim Vorhandensein eines Rekruitments. Durch die Dynamik-Kompression wird die reale akustische Umgebung in den Restdynamikbereich des schwerhörigen Benutzers abgebildet. Dabei wird der Restdynamikbereich durch die Hörschwelle und die Unbehaglichkeitsschwelle des Benutzers festgelegt. Der Restdynamikbereich ist frequenzabhängig.

Die Abbildung der realen akustischen Umgebung auf den Restdynamikbereich des Schwerhörigen wird durch eine automatische Verstärkungsregelung (AGC = Automatic Gain Control) erreicht. Dabei sind die Verwendung einer ausgangspegelgesteuerten Verstärkungsregelung (AGCO) sowie einer eingangspegelgesteuerten Verstärkungsregelung (AGCI) bekannt.

Als Beispiel einer ausgangspegelgesteuerten Dynamikkompression ist z.B. aus der Druckschrift WO00/47014 eine sog. ADRO-(Adaptive Dynamic Range Optimisation) Kompression bekannt. Dabei wird der Ausgangspegel zur Steuerung der Verstärkung herangezogen, und zwar sowohl zur Pegelbegrenzung als auch zur (langsamen) Komprimierung über den gesamten Dynamikbereich, wobei versucht wird, eine lineare Verstärkung und deren Vorteile im Bezug auf Klang- und Sprachverstehen im Störgeräusch zu applizieren.

Aus der Druckschrift DE 10 2005 061 000 A1 ist die Verwendung einer ausgangspegelgesteuerten und einer eingangspegelgesteuerten Dynamikkompression in einem Hörhilfegerät bekannt. Anhand der Zuordnung des Eingangssignals in das betreffende Hörhilfegerät zu einer bestimmten Hörumgebung (Klassifikation) wird zwischen den unterschiedlichen Dynamikkompressionen umgeschaltet.

Aus der Druckschrift DE 10 2009 004 185 A1 ist die gleichzeitige Anwendung sowohl einer ausgangspegelgesteuerten Dynamikkompression als auch einer eingangspegelgesteuerten Dynamikkompression in einem Hörhilfegerät bekannt, wobei die unterschiedlichen Dynamikkompressionen in zwei parallelen Signalpfaden ausgeführt werden und die beiden Signalpfade in von der Klassifikation abhängiger Gewichtung zusammengeführt werden.

Umfangreiche Untersuchungen mit den unterschiedlichen Dynamikkompressionen haben ergeben, dass es sinnvoll ist, in bestimmten Hörsituationen einer der beiden Kompressionen den Vorzug zu geben. Die Auswahl bzw. Gewichtung kann z.B. auf Basis eines Klassifikationssystems erfolgen, das entscheidet, in welcher akustischen Hörumgebung sich das Hörhilfegerät gerade befindet. So wird z.B. in einer sehr lauten Hörumgebung eine ausgangspegelgesteuerte Dynamikkompression (AGCO), z.B. die ADRO- (Adaptive Dynamic Range Optimisation) Kompression bevorzugt. Wird hingegen eine Hörsituation detektiert, in der ein starkes Sprachsignal vorhanden ist, so wird eine eingangspegelgesteuerte Dynamikkompression (AGCI), z.B. die WDRC- (Wide Dynamic Range Compression) Kompression bevorzugt. Insbesondere haben die erwähnten Studien gezeigt, dass die Art der Kompression Einfluss auf die Wahrnehmung eines bestimmten Eingangssignals hat. So zeigt sich beispielsweise bei der ADRO-Kompression ein deutlicher Einfluss auf das Lautheitsempfinden, während die WDRC-Kompression die Wahrnehmung von Sprache verbessert. Es ist daher vorteilhaft, die Dynamikkompression in Abhängigkeit der Klassifikation auszuführen.

Aufgabe der vorliegenden Erfindung ist es, die Wahrnehmung akustischer Signale bei der Versorgung mit einem Hörhilfegerät weiter zu verbessern.

Diese Aufgabe wird durch ein Verfahren zur Signalverarbeitung in einem Hörhilfegerät mit den im Anspruch 1 angegebenen Verfahrensschritten gelöst. Ferner wird die Aufgabe durch ein Hörhilfegerät mit den in Anspruch 12 angegebenen Merkmalen gelöst.

Die Erfindung sieht zunächst die Aufteilung eines akustischen Eingangssignals in mehrere Frequenzbänder (Kanäle) vor. Prinzipiell kann es sich dabei auch um eine sehr große Anzahl an Frequenzbändern handeln, wie sie beispielsweise bei der digitalen Transformation des Eingangssignals vom Zeitbereich in den Frequenzbereich, beispielsweise mittels einer digitalen FFT, entsteht. Üblicherweise erfolgt jedoch eine Aufteilung des akustischen Eingangssignals in eine überschaubare Anzahl an Frequenzbändern (z.B. 16) mittels einer Filterbank. Gemäß der Erfindung erfolgt nun in wenigstens einem der erzeugten Frequenzbänder eine eingangspegelgesteuerte Dynamikkompression (AGCI) und gleichzeitig in wenigstens einem anderen Frequenzband eine ausgangspegelgesteuerte Dynamikkompression (AGCO). Beispielsweise kann in wenigstens einem Frequenzband im Bereich tiefer Frequenzen des akustischen Eingangssignals eine ausgangspegelgesteuerte Kompression (AGCO) verwendet werden, da tiefe Frequenzen maßgeblich die Lautheitswahrnehmung beeinflussen, so dass im niedrigen Frequenzbereich eine Kompression vorteilhaft ist, die die Lautheitswahrnehmung positiv beeinflusst. Im oberen Frequenzbereich wird hingegen vorteilhaft eine eingangspegelgesteuerte Kompression verwendet, da dieser Frequenzbereich für das Sprachverstehen im Vordergrund steht und sich eine eingangspegelgesteuerte Kompression (AGCI) vorteilhaft auf das Sprachverstehen auswirkt. Vorteilhaft ist es bei einem erfindungsgemäßen Hörhilfegerät jedoch möglich, jedem Kanal eine beliebige Kompression zuzuordnen.

Eine Ausführungsform der Erfindung sieht vor, in wenigstens einem Frequenzband den Signalpfad in wenigstens zwei parallele Signalpfade aufzuteilen. Dabei wird in einem ersten Signalpfad innerhalb des betreffenden Frequenzbandes eine eingangspegelgesteuerte Dynamikkompression (AGCI) und in einem zweiten Signalpfad des betreffenden Frequenzbandes eine ausgangspegelgesteuerte Dynamikkompression (AGCO) ausgeführt, bevor die Signalpfade wieder zusammengeführt werden. Dies hat den Vorteil, dass in dem betreffenden Frequenzband zwischen den unterschiedlichen Kompressionsarten umgeschaltet werden kann, und zwar unabhängig von der gewählten Kompressionsart in einem anderen Frequenzband. Die Signalverarbeitung des Hörhilfegerätes lässt sich dadurch besser an unterschiedliche Hörsituationen anpassen.

Bei einer weiteren Ausführungsform der Erfindung, bei der die Signalverarbeitung in wenigstens einem Frequenzband in wenigstens zwei parallelen Signalpfaden erfolgt, wird nicht zwischen den einzelnen Signalpfaden umgeschaltet, sondern die Signalpfade werden nach der jeweiligen Ausführung unterschiedlicher Dynamikkompressionen in einem bestimmten Mischverhältnis, d.h. in unterschiedlicher Gewichtung zusammengeführt. Dies erlaubt eine noch bessere Anpassung der Signalverarbeitung in dem betreffenden Hörhilfegerät an unterschiedliche Hörsituationen. Das beschriebene System würde eine Klassifikation grundsätzlich nicht mehr erfordern, da die Signalverarbeitung ständig mit einer eingangspegelgesteuerten und ausgangspegelgesteuerten Dynamikkompression betrieben wird. Die unterschiedlichen Kompressionsverfahren könnten jedoch auch automatisch in Abhängigkeit der Klassifikation frequenzabhängig zu- bzw. abgeschaltet werden oder in unterschiedlicher Gewichtung in dem jeweiligen Frequenzband miteinander verknüpft werden. Diese Umschaltung bzw. Mischung erfolgt vorteilhaft nicht nur auf Basis der Klassifikation, die eher physikalische Größen berücksichtigt, sondern auch unter Einbeziehung psychoakustischer Größen.

Insgesamt bietet die Erfindung den Vorteil, dass ein erfindungsgemäßes Hörhilfegerät auch in Hinblick auf die Dynamikkompression frequenzspezifisch arbeitet. So können in einer bestimmten akustischen Situation gleichzeitig die Vorteile einer eingangs- und einer ausgangsbezogenen Verstärkungsregelung ausgenutzt werden.

Bei einer bevorzugten Ausführungsform der Erfindung ist die eingangspegelgesteuerte Dynamikkompression (AGCI) als WDRC-(Wide Dynamic Range Compression) Kompression ausgeführt. Weiterhin ist bei einer vorteilhaften Ausführungsform der Erfindung die ausgangspegelgesteuerte Kompression (AGCO) als ADRO-(Adaptive Dynamic Range Optimisation) Kompression ausgeführt.

Die Zuordnung der unterschiedlichen Kompressionsverfahren zu den einzelnen Frequenzbändern bzw. zu den einzelnen Signalpfaden innerhalb der einzelnen Frequenzbänder kann vorteilhaft durch Programmierung eines betreffenden Hörhilfegerätes festgelegt werden, beispielsweise durch einen Hörgeräteakustiker. Weiterhin ist vorteilhaft bei einem Hörhilfegerät mit mehreren parallelen Signalpfaden innerhalb eines Frequenzbandes, in denen unterschiedliche Dynamikkompressionen ausgeführt werden, auch das Mischverhältnis zwischen den einzelnen Signalpfaden durch Programmierung einstellbar. Die Einstellung erfolgt dabei vorzugsweise auch in Abhängigkeit des individuellen Hörverlustes des Benutzers.

Bei einer besonders vorteilhaften Ausführungsform der Erfindung können sich die Zuordnung der unterschiedlichen Kompressionsverfahren zu den einzelnen Frequenzbändern sowie ggf. auch das Mischverhältnis der parallelen Signalpfade innerhalb eines Frequenzbandes im laufenden Betrieb eines betreffenden Hörhilfegerätes ändern. Die Einstellung erfolgt vorteilhaft adaptiv in Abhängigkeit der aktuellen Hörsituation, in der das Hörhilfegerät betrieben wird und die mit Hilfe eines Klassifikators festgestellt wird.

Die Erfindung wird nachfolgend anhand eines Ausführungsbeispiels näher erläutert. Dabei zeigen:
- FIG 1: das Blockschaltbild eines Hörhilfegerätes mit einer eingangspegelgesteuerten Dynamikkompression,
- FIG 2: das Blockschaltbild eines Hörhilfegerätes mit einer ausgangspegelgesteuerten Dynamikkompression,
- FIG 3: das Blockschaltbild eines Hörhilfegerätes mit sowohl einer eingangspegelgesteuerten als auch einer ausgangspegelgesteuerten Dynamikkompression in zwei parallelen Signalpfaden,
- FIG 4: das Blockschaltbild eines Hörhilfegerätes gemäß der Erfindung,
- FIG 5: das Blockschaltbild eines weiteren Hörhilfegerätes gemäß der Erfindung und
- FIG 6: ein Ablaufschema zur Signalverarbeitung in einem erfindungsgemäßen Hörhilfegerät.

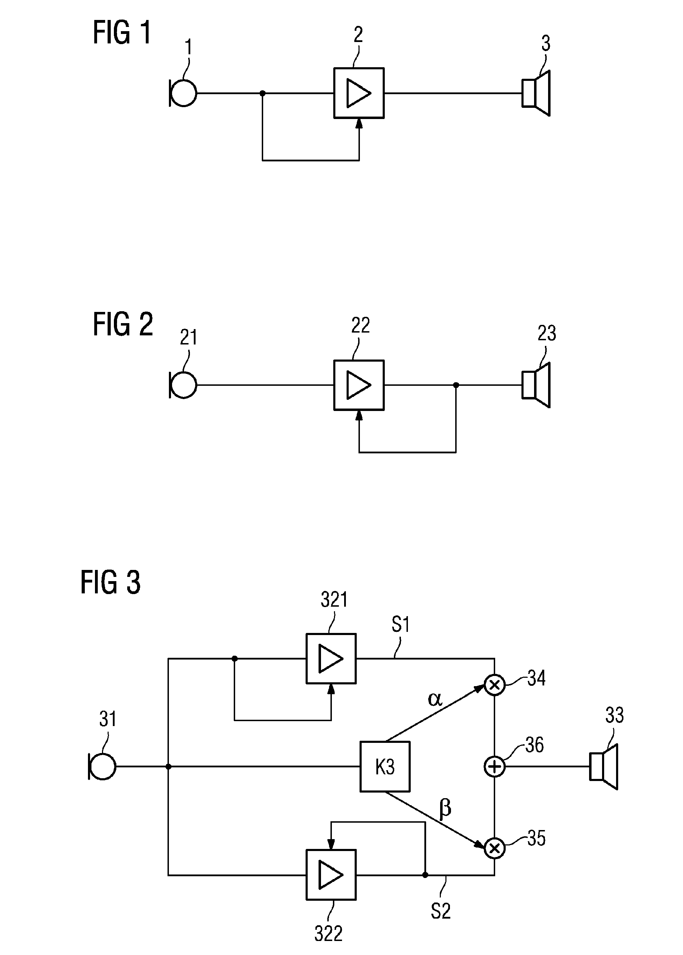

FIG 1 zeigt im stark vereinfachten Blockschaltbild ein Hörhilfegerät mit einer eingangspegelgesteuerten Dynamikkompression (AGCI) gemäß dem Stand der Technik. Dabei wird ein akustisches Eingangssignal von einem Mikrofon 1 aufgenommen, in einer Signalverarbeitungseinheit 2 frequenzabhängig verarbeitet und verstärkt und schließlich zum Erzeugen eines akustischen Ausgangssignals einem Hörer 3 zugeführt. Es erfolgt eine eingangspegelgesteuerte Regelung der Verstärkung (AGCI).

Mögliche regelbare Parameter sind beispielsweise die Kompressionsrate, die Verstärkung oder eine Zeitkonstante der Regelung.

Analog zu FIG 1 zeigt auch FIG 2 das Blockschaltbild eines Hörhilfegerätes gemäß dem Stand der Technik mit einem Mikrofon 21, einer Signalverarbeitungseinheit 22 und einem Hörer 23. Im Unterschied zu FIG 1 erfolgt dabei jedoch eine ausgangspegelgesteuerte Dynamikkompression (AGCO). Dabei kann besonders vorteilhaft ein maximaler Ausgangspegel bei dem betreffenden Hörhilfegerät eingestellt werden.

Ein weiteres Blockschaltbild eines Hörhilfegerätes gemäß dem Stand der Technik zeigt FIG 3. Bei dieser Ausführungsform erfolgt eine Aufspaltung des von dem Mikrofon 31 ausgehenden Eingangssignals, sodass die Signalverarbeitung in zwei parallelen Signalpfaden erfolgt. Dabei wird in dem ersten Signalpfad mittels einer ersten Signalverarbeitungseinheit 321 das Signal S1 unter Anwendung einer eingangspegelgesteuerten Dynamikkompression und in dem parallelen zweiten Signalpfad mittels einer zweiten Signalverarbeitungseinheit 322 das Signal S2 unter Anwendung einer ausgangspegelgesteuerten Dynamikkompression erzeugt. Weiterhin ist das Eingangssignal einem Klassifikator K3 zugeführt, der das Eingangssignal analysiert und die augenblickliche Hörsituation, in der das Hörhilfegerät betrieben wird, feststellt. In Abhängigkeit des Klassifikationsergebnisses werden Gewichte α und β im Bereich von 0 bis 1 für die einzelnen Signalpfade festgelegt, mit denen die Signale S1 bzw. S2 der Signalpfade mittels der Multiplizierer 34 und 35 multipliziert werden, bevor eine Zusammenführung der Signalpfade in dem Summierer 36 und eine Signalausgabe über den Hörer 33 erfolgen.

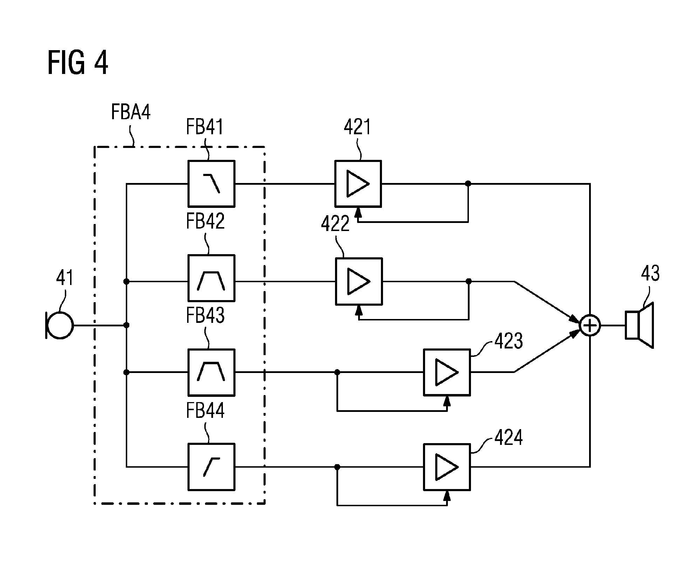

Ein beispielhaftes Blockschaltbild eines Hörhilfegerätes gemäß der Erfindung ist in FIG 4 wiedergegeben. Dabei erfolgt zunächst eine Aufteilung des von dem Mikrofon 41 erzeugten elektrischen Eingangssignals mittels einer Filterbank FBA4 in mehrere Frequenzbänder. Im Ausführungsbeispiel sind dies ein unteres Frequenzband FB41, zwei mittlere Frequenzbänder FB42 und FB43 sowie ein oberes Frequenzband FB44. Gemäß der Erfindung werden nun für unterschiedliche Frequenzbänder unterschiedliche Kompressionsarten gewählt. So werden im Ausführungsbeispiel für das untere Frequenzband FB41 und das erste mittlere Frequenzband FB42 eine ausgangspegelgesteuerte Dynamikkompression und für das zweite mittlere Frequenzband FB43 sowie für das obere Frequenzband FB44 eine eingangspegelgesteuerte Dynamikkompression festgelegt. Diese Wahl wirkt sich besonders vorteilhaft sowohl auf die Lautheitswahrnehmung als auch auf die Sprachverständlichkeit für ein akustisches Eingangssignal, welches einem Benutzer über das Hörhilfegerät zugeführt wird, aus.

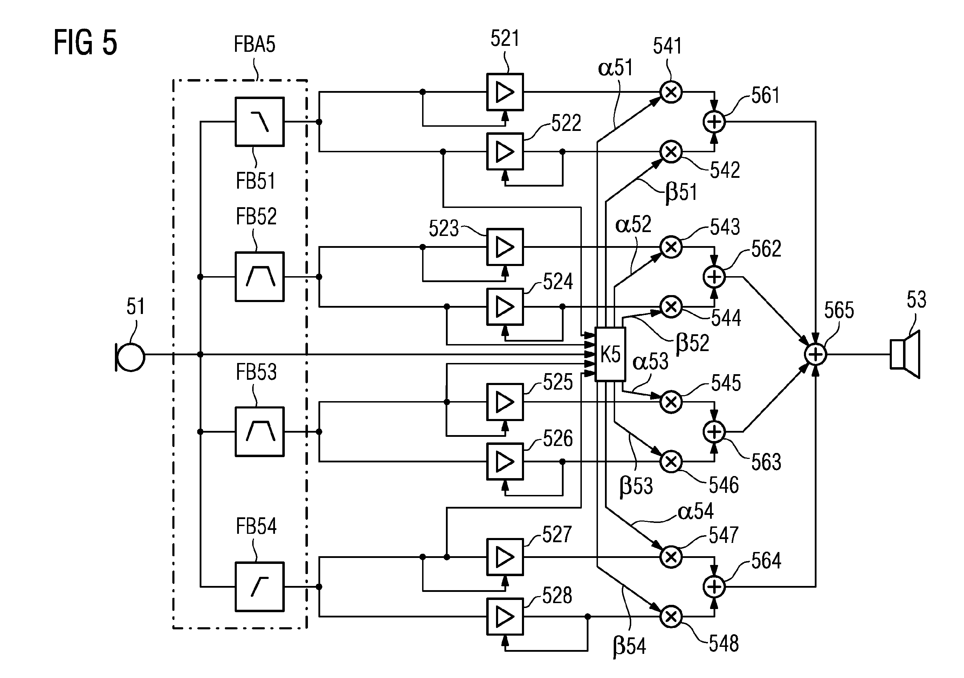

Eine besonders vorteilhafte Ausführungsform der Erfindung zeigt das Blockschaltbild gemäß FIG 5. Im Unterschied zum Ausführungsbeispiel gemäß FIG 4 sind dabei die elektrischen Ausgangssignale der Filterbank FBA5 für jedes Frequenzband in jeweils zwei parallele Signalpfade aufgespaltet. Dabei ist jeweils für den einen Signalpfad eine eingangspegelgesteuerte Dynamikkompression und für den anderen Signalpfad eine ausgangspegelgesteuerte Dynamikkompression vorgesehen. Im Einzelnen erfolgt für das Frequenzband FB51 eine eingangspegelgesteuerte Dynamikkompression in der Signalverarbeitungseinheit 521 sowie parallel eine ausgangspegelgesteuerte Dynamikkompression in der Signalverarbeitungseinheit 522. Die beiden parallelen Signalpfade des Frequenzbandes FB51 werden durch Multiplikation mit den Faktoren α51 bzw. β51 in den Multiplizierern 541 und 542 unterschiedlich gewichtet und im Addierer 561 addiert. Eine analoge Vorgehensweise erfolgt auch für die weiteren Frequenzbänder FB52 bis FB54. Dabei liegen die Faktoren vorzugsweise jeweils im Bereich von 0 bis 1. Die Faktoren können sich dabei zwischen den einzelnen Frequenzbändern unterscheiden. Schließlich werden die resultierenden Signale im Addierer 565 addiert und über den Hörer 53 ausgegeben.

Werden für die Faktoren nur die Zahlenwerte 0 oder 1 zugelassen, so kann in jedem Frequenzband zwischen den unterschiedlichen Dynamikkompressionen umgeschaltet werden. Selbstverständlich ist dabei auch ein gleitender Übergang möglich, indem nicht hart zwischen 0 und 1 umgeschaltet wird.

Die einzelnen Gewichte der Signalpfade sind vorteilhaft durch Programmierung des betreffenden Hörhilfegerätes einstellbar. Vorzugsweise erfolgt eine dynamische Anpassung der Gewichte während des laufenden Betriebes des Hörhilfegerätes. Hierfür werden in der Klassifikations- und Steuereinheit K5 das von dem Mikrofon 51 abgegebene elektrische Eingangssignal sowie die Ausgangssignale der Filterbank FBA5 zugeführt und analysiert. In Abhängigkeit von der erkannten Hörsituation werden dann die Gewichte entsprechend eingestellt. So können beispielsweise in der Hörsituation "Sprache in Störlärm" die Gewichte so eingestellt werden, dass eine Signalverarbeitung durch das Hörhilfegerät entsprechend dem Ausführungsbeispiel gemäß FIG 4 resultiert. Dadurch werden sowohl die Sprachverständlichkeit als auch der Lautheitseindruck optimiert. Vorzugsweise ergibt die Summe der Faktoren für jedes Frequenzband den Wert 1, so dass die Frequenzbänder untereinander gleich gewichtet sind. Es ist jedoch auch eine unterschiedliche Gewichtung der Frequenzbänder möglich.

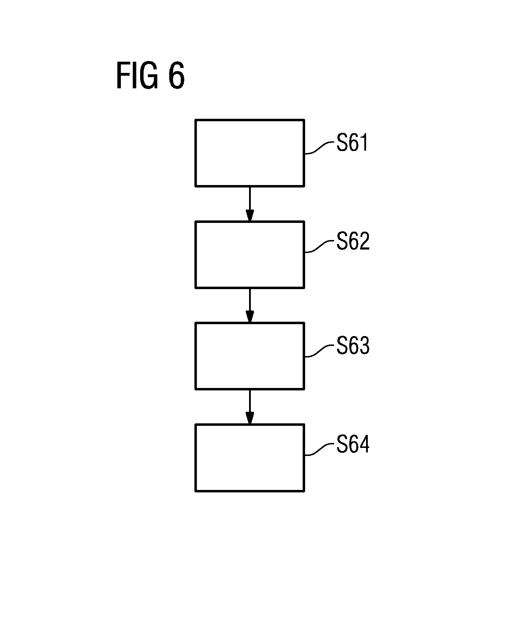

FIG 6 zeigt ein Ablaufdiagramm zur Durchführung eines erfindungsgemäßen Verfahrens zur Signalverarbeitung in einem Hörhilfegerät. Dabei erfolgt in einem ersten Verfahrensschritt S61 eine Aufteilung eines elektrischen Eingangssignals in mehrere Frequenzbänder. Anschließend erfolgt in einem Verfahrensschritt S62 eine eingangspegelgesteuerte Dynamikkompression in wenigstens einem ersten Frequenzband und parallel dazu in einem Verfahrensschritt S63 eine ausgangspegelgesteuerte Dynamikkompression in wenigstens einem zweiten Frequenzband, bevor die unterschiedlich verarbeiteten Signale in einem Verfahrensschritt S64 zu einem Ausgangssignal zusammen geführt (addiert) und ausgegeben werden.

## Patentansprüche

1. Verfahren zur Signalverarbeitung in einem Hörhilfegerät durch
- Aufteilung eines Eingangssignals in mehrere Frequenzbänder (FB41, FB42, FB43, FB44),
- Ausführen einer eingangspegelgesteuerten Dynamikkompression in wenigstens einem ersten Frequenzband (FB43, FB44),
- Ausführen einer ausgangspegelgesteuerten Dynamikkompression in wenigstens einem zweiten Frequenzband (FB41, FB42).

2. Verfahren nach Anspruch 1, wobei das erste und/oder das zweite Frequenzband (FB51, FB52, FB53, FB54) in wenigstens zwei parallele Signalpfade aufgespaltet wird, wobei in dem ersten Signalpfad eine eingangspegelgesteuerte und in dem zweiten Signalpfad eine ausgangspegelgesteuerte Dynamikkompression ausgeführt wird.

3. Verfahren nach Anspruch 2, wobei in dem ersten und/oder dem zweiten Frequenzband (FB51, FB52, FB53, FB54) zur Erzeugung eines Ausgangssignals des betreffenden Frequenzbandes zwischen dem ersten Signalpfad und dem zweiten Signalpfad umgeschaltet wird.

4. Verfahren nach Anspruch 2, wobei in dem ersten und/oder zweiten Frequenzband (FB51, FB52, FB53, FB54) die Signalpfade nach der Dynamikkompression in einem bestimmten Mischverhältnis zusammen geführt werden.

5. Verfahren nach Anspruch 4, wobei sowohl das erste Frequenzband (FB51) als auch das zweite Frequenzband (FB52) in jeweils zwei Signalpfade unterteilt wird und sich das Mischverhältnis in dem ersten Frequenzband (FB51) von dem Mischverhältnis in dem zweiten Frequenzband (FB52) unterscheidet.

6. Verfahren nach einem der Ansprüche 1 bis 5, wobei die eingangspegelgesteuerte Dynamikkompression als WDRC-Kompression ausgeführt wird.

7. Verfahren nach einem der Ansprüche 1 bis 6, wobei die ausgangspegelgesteuerte Dynamikkompression als ADRO-Kompression ausgeführt wird.

8. Verfahren nach einem der Ansprüche 1 bis 7, wobei in wenigstens einem Frequenzband (FB41) in einem unteren, von dem Hörhilfegerät übertragbaren Frequenzbereich eine ausgangspegelgesteuerte Dynamikkompression ausgeführt wird.

9. Verfahren nach einem der Ansprüche 1 bis 8, wobei in wenigstens einem Frequenzband (FB44) in einem oberen, von dem Hörhilfegerät übertragbaren Frequenzbereich eine eingangspegelgesteuerte Dynamikkompression ausgeführt wird.

10. Verfahren nach einem der Ansprüche 1 bis 9, wobei die Zuordnung der unterschiedlichen Dynamikkompressionen zu den einzelnen Frequenzbändern durch Programmierung des Hörhilfegerätes erfolgt.

11. Verfahren nach einem der Ansprüche 1 bis 10, wobei die Zuordnung der unterschiedlichen Dynamikkompressionen zu den einzelnen Frequenzbändern (FB41, FB42, FB43, FB44; FB51, FB52, FB53, FB54) bzw. das Mischverhältnis der Signalpfade in wenigstens einem Frequenzband (FB51, FB52, FB53, FB54) in Abhängigkeit der augenblicklichen Hörsituation, in der sich das Hörhilfegerät befindet, erfolgen.

12. Hörhilfegerät zur Durchführung eines Verfahrens nach einem der Patentansprüche 1 bis 11 mit einem Eingangswandler (1, 31, 41, 51) zur Aufnahme eines akustischen Eingangssignals und Wandlung in ein elektrisches Eingangssignal, einer Filterbank (FBA4, FBA5) zur Aufteilung des elektrischen Eingangssignals in mehrere Frequenzbänder (FB41, FB42, FB43, FB44; FB51, FB52, FB53, FB54), Mitteln zur Ausführung einer ausgangspegelgesteuerten Dynamikkompression in wenigstens einem ersten Frequenzband (FB41, FB42), Mitteln zur Ausführung einer eingangspegelgesteuerten Dynamikkompression in wenigstens einem zweiten Frequenzband (FB43, FB44), Mitteln zum Zusammenführen der Ausgangssignale der einzelnen Frequenzbänder (FB41, FB42, FB43, FB44; FB51, FB52, FB53, FB54) zu einem elektrischen Gesamt-Ausgangssignal sowie Mitteln zum Wandeln des elektrischen Gesamt-Ausgangssignals in ein von einem Benutzer als akustisches Ausgangssignal wahrnehmbares Ausgangssignal.

13. Hörhilfegerät nach Anspruch 12, wobei der Signalpfad wenigstens eines Frequenzbandes (FB51, FB52, FB53, FB54) in zwei parallele Signalpfade aufgespaltet ist und in dem ersten Signalpfad Mittel zur Ausführung einer eingangspegelgesteuerten Dynamikkompression und in dem zweiten Signalpfad Mittel zur Ausführung einer ausgangspegelgesteuerten Dynamikkompression vorhanden sind.

14. Hörhilfegerät nach Anspruch 13, wobei Mittel zur unterschiedlichen Gewichtung und Zusammenführung der Signalpfade vorhanden sind.

15. Hörhilfegerät nach einem der Ansprüche 12 bis 14, umfassend eine Klassifikations- und Steuereinheit (K3; K5) zum Erkennen der akustischen Hörsituation, in der sich das Hörhilfegerät befindet, sowie zur Festlegung der Art der Dynamikkompression in wenigstens einem Frequenzband und/oder zur Bestimmung der Gewichte der einzelnen Signalpfade.

16. Hörhilfegerät nach einem der Ansprüche 12 bis 15, wobei die Zuordnung der unterschiedlichen Dynamikkompressionen zu den einzelnen Frequenzbändern durch Programmierung des Hörhilfegerätes festlegbar ist.

17. Hörhilfegerät nach einem der Ansprüche 12 bis 16, wobei die Zuordnung der unterschiedlichen Dynamikkompressionen zu den einzelnen Frequenzbändern (FB41, FB42, FB43, FB44; FB51, FB52, FB53, FB54) bzw. das Mischverhältnis der Signalpfade in wenigstens einem Frequenzband (FB51, FB52, FB53, FB54) in Abhängigkeit der augenblicklichen Hörsituation, in der sich das Hörhilfegerät befindet, automatisch einstellbar ist.
